# EUROPÄISCHE PATENTSCHRIFT

(11) **EP 0 518 109 B1**
(45) Veröffentlichungstag und Bekanntmachung des Hinweises auf die Patenterteilung: **28.01.1998**
(21) Anmeldenummer: 92108771.4
(22) Anmeldetag: 25.05.1992
(51) Int. Cl.: C23C 14/56, C23C 14/50, C23C 14/34, H01L 21/00

(54) **Vakuumbehandlungsanlage**
Apparatus for vacuum treatment
Système de traitement sous vide

(30) Priorität: 31.05.1991 DE 4117969
(43) Veröffentlichungstag der Anmeldung: 16.12.1992
(73) Patentinhaber: BALZERS AKTIENGESELLSCHAFT, 9496 Balzers (LI)
(72) Erfinder: Schertler, Roman, A-6922 Wolfrut (AT)
(74) Vertreter: Troesch Scheidegger Werner AG

(56) Entgegenhaltungen:
- EP-A- 136 562
- EP-A- 161 927
- EP-A- 389 820
- DE-A- 2 529 018

## Beschreibung

In sich geschlossene Transportkammern für eine Vakuumbehandlungsanlage

Die vorliegende Erfindung betrifft eine Transportkammer nach dem Oberbegriff von Anspruch 1 bzw. 2 deren Verwendung nach Anspruch 15, eine Vakuumbehandlungsanlage gemäss Anspruch 14 und ein Transportverfahren gemäss Anspruch 17, jeweils mit Verwendung einer der Kammern nach den Ansprüchen 1 oder 2.

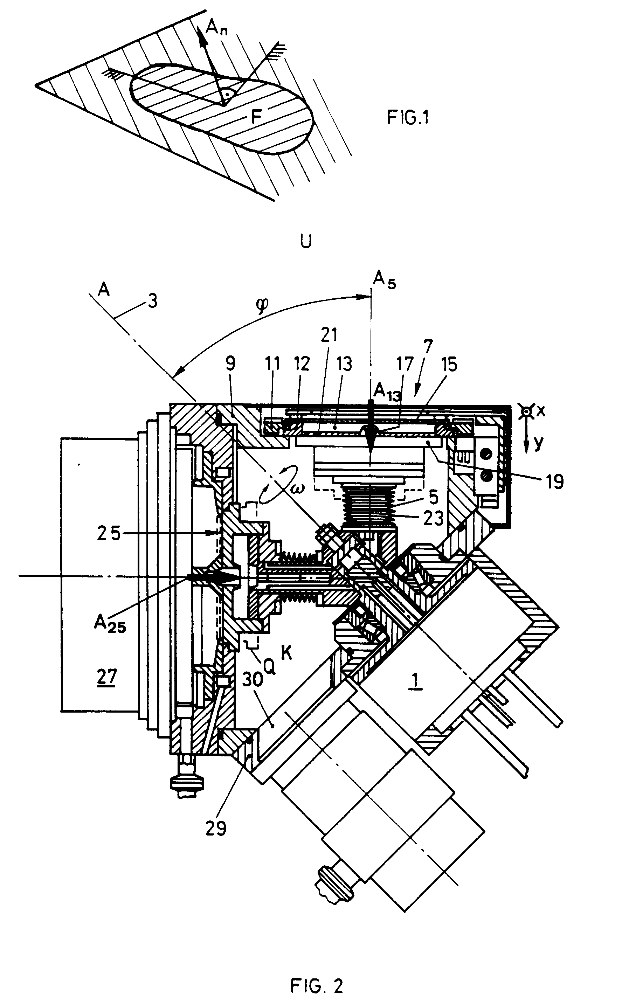

Es sind Vakuumbehandlungsanlagen bekannt, beispielsweise aus der DE-A-24 54 544 oder aus Patents Abstracts of Japan, 28. Nov. 1989, Vol. 13, No. 532, betr. JP-A2 1-218627, welche mindestens zwei Stationen umfassen, je mit mindestens einer Zuführ- und/oder Entnahmeöffnung für den Gegenstand, wobei die Oeffnungen je eine Flächen-Normalachse Aₙ, zu ihrer Oeffnungsfläche F, festlegen, wie in Fig. 1 zur Klarstellung festgelegt. Diese Anlagen weisen weiter eine Vakuumkammer auf mit einer Transporteinrichtung, die um eine Raumachse getrieben drehbeweglich gelagert ist, mit mindestens einer Halterung für ein Werkstück, wobei die Transporteinrichtung sukzessive an die Oeffnungen zu den Stationen bewegt wird.

Im Gegensatz zur angegebenen Darstellung in der JP-A-1-218627, deren drehbare Transporteinrichtung lediglich eine Halterung für ein Werkstück aufweist, welche starr an einem die Transporteinrichtung bildenden Drehzylinder vorgesehen ist, sind an der Transporteinrichtung gemäss der DE-A-24 54 544 vier Halterungen für Werkstücke vorgesehen, welche daran parallel zur Drehachse der Transporteinrichtung beweglich gelagert sind. Mittels durch die Wandung der Kammer durchgreifender Antriebsstempel als Vorschubeinrichtung erfolgt die individuell getriebene Bewegung der Halterungen bezüglich der Stationsöffnungen.

Es können gemäss der DE-A-24 54 544 die Halterungen je nach Erfordernis unterschiedlich bezüglich der genannten Stationen positioniert werden, bis hin zum dichten Verschliessen der entsprechenden Oeffnungen.

Das Vorsehen der genannten, durch die Kammerwand durchgreifenden Antriebsstempel als Vorschubantrieb ist unter den folgenden Aspekten nachteilig:
a) Es muss für jeden Antriebsstempel, d.h. jede Vorschubeinrichtung, eine dynamische Gleitvakuumdichtung vorgesehen werden, was unter vakuumtechnischem Aspekt aufwendig ist.
b) Die Antriebsstempel, d.h. Vorschubeinrichtungen, sind je einer der vorgesehenen Stationen fest zugeordnet. Damit erfordert eine Aenderung, insbesondere Erhöhung der an einer Kammer vorgesehenen Stationenzahl praktisch eine Neukonzipierung der Kammer mit geänderter Anzahl vakuumdicht durchgeführter Antriebsstempel.

Aus der EP-A-0 136 562 ist an einer Vakuumbehandlungsanlage mit mehreren sternförmig angeordneten Stationen eine zentral gelegene Kammer mit einer Werkstück-Transporteinrichtung bekannt, welche karussellartig in der Kammer um eine Achse drehbeweglich ist.

Auf die Stationen, bezüglich der Drehachse der Transporteinrichtung radial ausgerichtet, sind, als Vorschubeinrichtungen, Stössel vorgesehen. Als Antrieb für alle Stössel ist zentral ein in Richtung der Drehachse verschieblicher Konus vorgesehen, welcher auf die zentral innen gelegenen Endpartien der Stössel einwirkt. An dieser Anlage sind die Stössel, als Vorschubeinrichtungen, je einer der vorgesehenen Stationen fest zugeordnet. Auch hier erfordert eine Aenderung, insbesondere Erhöhung der an der Kammer angeordneten Stationen, eine Neukonzipierung der erwähnten Kammer, und zudem müssen alle Stationen synchron mit Werkstücken bedient werden.

Aehnlich wie aus der EP-A-0 136 562 bekannt, wird auch gemäss der DE-OS-25 29 018 in einer Kammer eine drehbare Transporteinrichtung vorgesehen, woran, eine Kegelfläche überstreichend, Stössel mit endständigen Halterungen je für Werkstücke angeordnet sind. Der Antrieb der Stössel erfolgt mittels eines ebenfalls in der Drehachse wirkenden Antriebskonus, welcher, unabhängig von der Transporteinrichtung gelagert, axial vor- und rückgetrieben wird.

Die vorliegende Erfindung setzt sich zum Ziel, die Einsatzflexibilität von Kammern der in der DE-OS-24 54 544 einerseits, der EP-A-0 136 562 bzw. der DE-OS-25 29 018 anderseits bekannten Art wesentlich zu erhöhen, und zwar, sowohl was Konfiguration von Vakuumbehandlungsanlagen mit einer solchen Kammer anbelangt, wie auch, was die Bedienung von Stationen an einer solchen Kammer anbelangt.

Dies wird, ausgehend von einer Kammer der in der DE-OS-24 54 544 vorbekannten Art, durch deren Ausbildung nach dem kennzeichnenden Teil von Anspruch 1 erreicht.

Ausgehend von Kammern der in der EP-A-0 136 562 bzw. der DE-OS-25 29 018 vorbekannten Art wird diese Aufgabe durch Ausbildung nach dem kennzeichnenden Teil von Anspruch 2 erreicht.

Dadurch wird eine derartige Kammer mit integrierten Antriebsmitteln geschaffen, die, höchst flexibel ansteuerbar, für bezüglich Stationenzahl unterschiedlich konzipierte Anlagen eingesetzt werden kann und gleichzeitig das Problem der obgenannten Dichtungen einerseits löst, anderseits das Problem nur synchron bedienbarer Stationen.

Im weiteren ist die eingangs genannte Art von Vakuumbehandlungsanlagen, insbesondere nach der DE-A-24 54 544, welche sich auf dem Markt etabliert hat, dadurch nachteilig, dass die Raumachse, um welche die Transporteinrichtung drehbeweglich ist und die Normalachsen zu den Oeffnungsflächen der Stationen parallel zueinander stehen, meistens dabei die Stationenöffnungen aequidistant um die Raumachse angeordnet sind, wodurch einerseits, als Vorteil, die Bedienung der Stationenöffnungen allein mit einer Schwenkbewegung der Transporteinrichtung um die erwähnte Raumachse erfolgen kann, anderseits aber mit dem Nachteil verbunden, dass man bei der Auslegung der Vakuumbehandlungsanlage insofern gebunden ist, als dass die einzelnen Stationen räumlich mit den erwähnten, zur Raumachse parallelen Oeffnungsachsen angeordnet werden müssen. Dies bedingt, dass die erwähnten Stationen in der gegebenen Ausrichtung, gegebenenfalls beidseitig der durch die Transporteinrichtung überstrichenen Fläche, angeordnet werden müssen.

Durch den Aufbau der erfindungsgemässen Anlage nach Anspruch 5 wird eine Anlage geschaffen, bei welcher die gegenseitige räumliche Anordnung der Stationen mit ihren Oeffnungen bezüglich der erwähnten Raumachse für die Transporteinrichtung in weiten Grenzen frei gewählt werden kann, womit sie höchst kompakt aufgebaut werden kann. Dabei wird der konstruktive Freiheitsgrad für Zuführungen, Bedienung, Montage, Demontage etc. einzelner Stationen wesentlich erhöht.

Es wird grundsätzlich erkannt, dass man, bei Beibehaltung einer Transporteinrichtung, welche um die erwähnte Raumachse drehbeweglich ist, trotz individuell getrieben bewegbarer Halterungen an der Transporteinrichtung, nicht an die bekannte achsparallele Konstruktionsrelation der Stationenöffnungen gebunden ist, und dass man, bei dem erwähnten erfindungsgemässen Kammeraufbau, ein Höchstmass an Konstruktionsflexibilität erzielt, sei dies, wie erwähnt, um Anlagen kompakter aufzubauen und/oder geringstmögliche zu evakuierende Räume zu schaffen und/oder um, in Funktion der Abstände einzelner Stationen, Behandlungszykluszeiten durch möglichst kurze Wege zu minimalisieren.

In einer bevorzugten Ausführungsvariante gemäss Wortlaut von Anspruch 8 überstreicht die Transporteinrichtung bei ihrer Drehbewegung um die Raumachse eine Kegelfläche gegebenen Oeffnungswinkels oder eine Ebene oder, gemäss Anspruch 9, eine Zylinderfläche.

Wiewohl die Transporteinrichtung, falls angezeigt, durchaus auch variabel verschiedene Kegelflächen überstreichen kann, indem der erwähnte Oeffnungswinkel ϕ getrieben gesteuert wird, hat es sich gezeigt, dass eine wesentliche Vereinfachung ohne wesentlichen Verlust an Flexibilität im Sinne der gestellten Aufgabe durch das erwähnte Vorgehen nach Anspruch 8 bzw. 9 erreicht wird. Wenn die Transporteinrichtung eine Kegelfläche überstreicht, bis hin zur ebenen Kreisfläche bei ϕ = 90°, bleibt vorerst weiterhin die Möglichkeit gegeben, mit dem vorgesehenen Vorschubantrieb den radialen Hub der Halterungen bezüglich der Drehachse zu verstellen, womit an der erwähnten Kegel fläche auch Stationen bzw. deren Oeffnungen erreichbar sind, die auf unterschiedlichen Grosskreisen am Kegel bzw. auf unterschiedlichen Kreisen in der ebenen Fläche (ϕ = 90°) liegen. Im weiteren brauchen dabei die Oeffnungsflächennormalen der Stationen nicht zwingend in Richtung der Kegelflächenmantellinien oder in radiale Richtung zu weisen, sondern können vorerst in beliebige Richtung weisen. Es wird dann die Halterung an der Transporteinrichtung entsprechend getrieben geschwenkt, um gegen eine entsprechende Stationenöffnung hin geführt zu werden.

Eine diesbezügliche weitere Vereinfachung ergibt sich bei der bevorzugten Ausführungsvariante gemäss Anspruch 8, bzw. 9, wenn welcher die Stationen so angeordnet sind, dass die Oeffnungsflächennormalen in Richtung von Mantellinien bzw. von Erzeugenden der Kegelfläche oder der Zylinderfläche weisen oder in Radialrichtung, je nachdem, ob Kegel-, Zylinder- oder Kreisfläche bei Drehbewegung durch die Transporteinrichtung überstrichen werden.

Obwohl die Transporteinrichtung z.B. als Transportkegel oder Transportscheibe ausgelegt werden kann, wird bevorzugterweise mindestens ein einseitig an der Drehachse drehbeweglich gelagerter Transportarm vorgesehen, an dessen anderem Ende die Halterung vorgesehen ist.

Je nach angestrebtem Bearbeitungszyklus, den an den Stationen eingerichteten Vakuumprozessen etc. wird an der einen und/oder anderen der Stationen und/oder an der erwähnten Kammer gemäss Anspruch 10 eine Gaszufuhr- und/oder Absaugeinrichtung vorgesehen. Somit ist es möglich, gezielt die Atmosphären in den Stationen und in der Kammer selektiv zu wählen, beispielsweise je nachdem, ob bei einem eingesetzten Verarbeitungsablauf die Vakuumatmosphäre in der einen Station durch diejenige in der Kammer und/oder in der anderen Station beeinflusst werden darf.

Bevorzugterweise weist weiter gemäss Wortlaut von Anspruch 11 und 12 die Halterung einen vorzugsweise in jeweiliger Oberflachennormalenrichtung bezüglich mindestens einer der Oeffnungen verschieblichen Teller auf, mit welchem vorzugsweise auch mindestens eine der Stationen gegenüber der Kammer abgetrennt wird.

Der erwähnte Teller kann Teil einer Zuführschleuse für einen Gegenstand in die Kammer bilden, oder es kann der erwähnte Teller, entsprechend ausgebildet, die Halterung bilden, welche, z.B. an einer Sputterstation, einerseits das Werkstück in den Prozess führt, anderseits die Sputterstation gegen die Kammer abdichtet.

Die Erfindung wird anschliessend beispielsweise anhand von Figuren erläutert.

Es zeigen:
- Fig. 2: eine Querschnittsdarstellung durch eine erfindungsgemässe Kammer mit zwei Stationen in einer ersten Ausführungsform;
- Fig. 3: eine teilweise geschnittene Darstellung einer erfindungsgemässen Kammer in einer weiteren Ausführungsform;
- Fig. 4: schematisch eine Aufsicht auf die Kammer gemäss Fig. 3;
- Fig. 5: eine Haltevorrichtung für scheibenförmige Gegenstände an einer Kammer gemäss den Fig. 2 bis 4;
- Fig. 6: schematisch das Prinzip der erfindungsgemässen Kammer gemäss den Fig. 2 bis 5;
- Fig. 7: schematisch analog zu Fig. 6 eine Weiterausbildung des Prinzips;
- Fig. 8: in Darstellung gemäss den Fig. 6 oder 7 eine noch weitere Ausbildungsvariante des Prinzips;
- Fig. 9: schematisch eine weitere Ausführungsvariante der erfindungsgemässen Kammer.

In Fig. 2 ist eine Querschnittsdarstellung einer erfindungsgemässen Vakuumbehandlungsanlage mit einer erfindungsgemässen Kammer K in einer ersten Variante dargestellt. Sie umfasst einen Antriebsmotor 1, auf dessen Drehachse A, und als physische Antriebsachse 3, mindestens ein Transportarm 5 mit seiner Achse A₅ gewinkelt, beispielsweise um 45° zur Achse A gewinkelt, befestigt ist. Wird mittels des Motors die Antriebsachse 3, wie bei ω dargestellt, in Drehung versetzt, so überstreicht der oder die Transportarm(e) 5 eine Kegelfläche mit 45° Kegelöffnungswinkel ϕ. In Fig. 2 sind zwei Stationen dargestellt. Eine erste Station 7 ist beispielsweise, und wie dargestellt, als Schleuse ausgebildet. Sie umfasst einen Rahmen 9, daran angeflanscht einen auf und ab beweglichen Rahmen 11. Innerhalb des getrieben auf und ab beweglichen Rahmens 11 liegt ein Dichtrahmen 12, der die Stationsöffnung 13 festlegt, mit Oeffnungsflächennormalen A₁₃. Die Schleusenstation 7 umfasst weiter einen Deckel 15, welcher linear in Richtung x verschieblich ist. Er kann selbstverständlich auch um eine in Fig. 2 vertikale Achse zum Oeffnen und Schliessen schwenkbar sein. Er wird in seiner geschlossenen, dargestellten Position, durch Absenken des Zwischenrahmens 11 in Richtung y, dichtend auf den Dichtrahmen 12 gelegt.

Damit wird die Schleusenstation 7 gegen die Umgebung U abgedichtet.

Der Transportarm 5 trägt, endständig, als Halterung, im weiteren Trägerpartie genannt, einen Teller 19, worauf ein zu behandelnder Gegenstand, im dargestellten Beispiel eine CD oder magneto-optische Speicherscheibe 21, ruht, zentriert durch einen Zapfen 17 am Teller 19. Wie gestrichelt dargestellt, kann am Trägerarm 5 der Teller 19 von seinem Sitz (eingezeichnet) am Dichtrahmen 12 gegen die Raumachse A rückgeholt werden und damit die Schleuse transporteinrichtungsseitig geöffnet werden. Da an der in Fig. 2 dargestellten Anlage die Transporteinrichtung 3, 5, 19 in der vakuumdichten Kammer K liegt, braucht hier der Teller 19 nicht dicht am Rahmen 12 anzuliegen. Dies ist selbstverständlich anders, wenn die Kammer K selbst nicht vakuumdicht ist. Der Gegenstand 21 wird mit dem Transportarm, durch Drehen der Welle 3 mittels des Motors 1, an die zweite dargestellte Station 27 gefördert. Der Rückholmechanismus bzw. Vorschubantrieb am Transportarm 5, dessen spezifischer Aufbau die vorliegende Erfindung an sich nicht tangiert und für welchen sich dem Fachmann manche Realisationsmöglichkeiten eröffnen, ist mit einem Balg 23 vakuumdicht gegen die Umgebung in der Kammer K abgedichtet. Durch Drehen des Transportarmes 5 wird nun der Gegenstand, nämlich die Scheibe 21, in den Bereich einer Oeffnung 25 der zweiten dargestellten Station 27 gefördert. Die Oeffnung 25 legt die Oeffnungsflächennormale A₂₅ fest. Aus der gestrichelt dargestellten Annäherungsposition Q heraus wird der Transportteller 19 mit der Scheibe 21 in die ausgezogen dargestellte Position mittels des erwähnten Vorschubantriebes, nämlich beispielsweise mittels eines pneumatischen Hubmechanismus am Arm 5, wieder angehoben, so dass sich der Teller 19, nun dichtend, an den Rand der Stationenöffnung 25 anlegt, welche beispielsweise als bekannte Aetzoder Beschichtungsstation ausgebildet sein kann.

Wie aus Fig. 2 ersichtlich, sind die Stationen 7 und 27 einerseits und der Flansch 29 des Motors 1 so miteinander verbunden, dass sie in der geschlossenen Kammer K einmünden, worin sich der Transportmechanismus, insbesondere mit dem oder den Armen 5, bewegt. Gegenüber der Umgebung U ist die Transporteinrichtungskammer K vorzugsweise vakuumdicht aufgebaut. Es werden nun, je nach Einsatzzweck (nicht dargestellt), an der Station 27 und/oder an der Kammer K und/oder an der Station 7 Einrichtungen vorgesehen, um gezielt jeweilige Atmosphären anzusteuern, d.h. es werden daran Evakuierungsanschlusse und/oder Gaseinlässe vorgesehen. Ein Pumpanschluss 30 für Kammer K und Schleuse 7 ist in Fig. 2 dargestellt.

Ist die Anlage so ausgebildet, dass gleichzeitig immer alle Stationenöffnungen durch einen der vorgesehenen Arme 5 dichtend verschlossen werden, so ergibt sich damit die Möglichkeit, die jeweiligen Atmosphären in den einzelnen Stationen, unabhängig von derjenigen in der Kammer K, vorzugeben. In gewissen Fällen kann es aber durchaus genügen, eine gemeinsame Atmosphäre für die vorgesehenen Stationen und die Transporteinrichtungskammer K vorzusehen, womit dann beispielsweise nur die Kammer K zu konditionieren bzw. zu evakuieren ist, wie in Fig. 2 z.B. dargestellt die Schleusenstation 7 und die Kammer K.

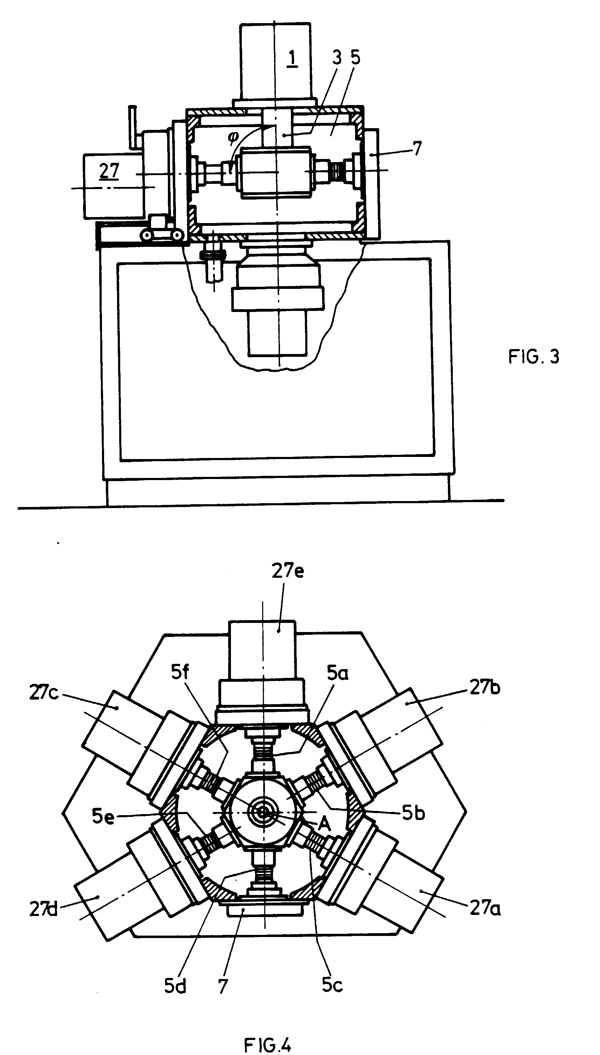

In Fig. 3 ist eine teilweise geschnittene Anlage dargestellt, bei der die Arme 5 von der Achse 3 des Motors 1 senkrecht aufragen, womit ϕ = 90° wird und die Transporteinrichtung eine Ebene überstreicht.

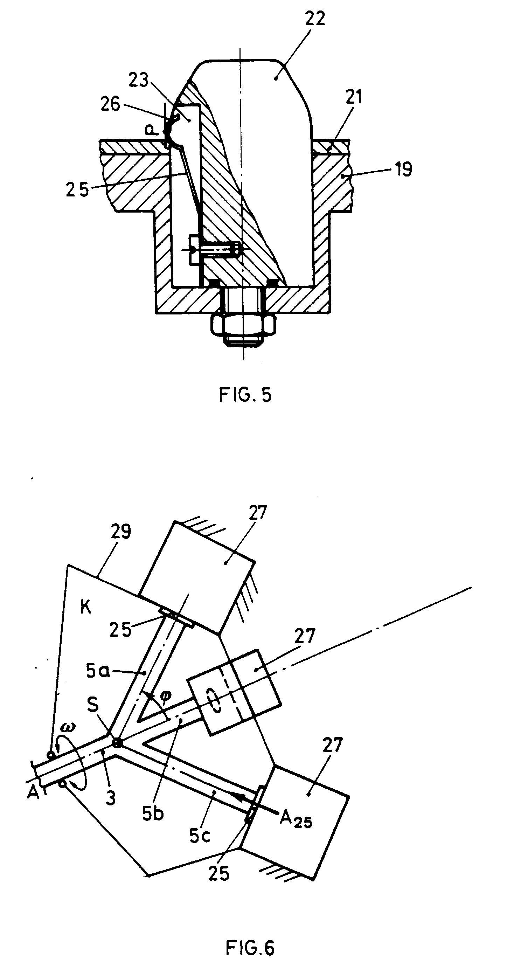

In Fig. 4 ist die Anlage nach Fig. 3 in Aufsicht dargestellt. Es bezeichnen gleiche Bezugszeichen die gleichen Bauelemente. Es sind um die Achse A z.B. sechs Transportarme 5a bis 5f angeordnet, analog wie in Fig. 3 ersichtlich, und sie bedienen abwechselnd eine Schleusenstation 7 für die Ein- und Ausgabe der Scheiben 21 und weitere fünf Bearbeitungsstationen 27a bis 27e.

Für die Behandlung von Gegenstandsscheiben, wie von CD oder magneto-optischen Scheiben, mit einem Zentrumsloch, wie die in Fig. 2 dargestellte Scheibe 21, zeigt Fig. 5 eine bevorzugte Halterung auf dem Teller 19. Demnach weist der Teller 19 in seinem Zentrum einen Zapfen 22 auf, der, azimutal um 120° versetzt, drei axial umlaufende Einkerbungen 23 aufweist. Darin sind Federn 25 befestigt. Sie ragen gegen das hochragende Ende des Zapfens 22 mit nach aussen gewölbten Partien 26 leicht über die Aussenfläche des Zapfens vor, derart, dass die Scheibe 21 leicht über diese Partien, z.B. mittels eines Zuführroboters, geschoben werden kann und ein geringfügiges Einrasten an den Partien 26 erfolgt. Dies in Abhängigkeit davon, wie stark die Partien 26 über die abgelegte Scheibe 21 ragen. Das leichte Einrasten, nur geringfügig über dem Kulminationspunkt P der Partien 26, erlaubt auch ein leichtes Abziehen der Scheibe 21 nach deren Behandlung, ohne dass daran ein getrieben bewegter Mechanismus nötig wäre.

In Fig. 6 ist die anhand der Fig. 2 bis 4 erläuterte Anlage in ihrem Grundprinzip schematisch dargestellt. Mit den z.B. drei hier dargestellten Transportarmen 5a bis 5c, um die Raumachse A drehend, werden, beispielsweise, die eingetragenen drei Stationen 27 mit ihren Oeffnungen 25 bedient. Wie mit der Begrenzung 29 schematisch eingetragen, ist eine Transporteinrichtungskammer K gebildet. Die Transporteinrichtung überstreicht bei ihrer Drehung ω eine Kegelfläche mit Oeffnungswinkel ϕ und bedient die Stationen 27, deren Oeffnungen 25 die Flächennormale A₂₅ festlegen. Letztere sind in Richtung von Mantellinien des überstrichenen Kegels gerichtet. Es liegen die Oeffnungen 25 der Stationen 27 auf einem Grosskreis der überstrichenen Kegelflächen, d.h. sie sind alle von der Spitze S des durch die Arme 5 überstrichenen Kegels gleich weit entfernt.

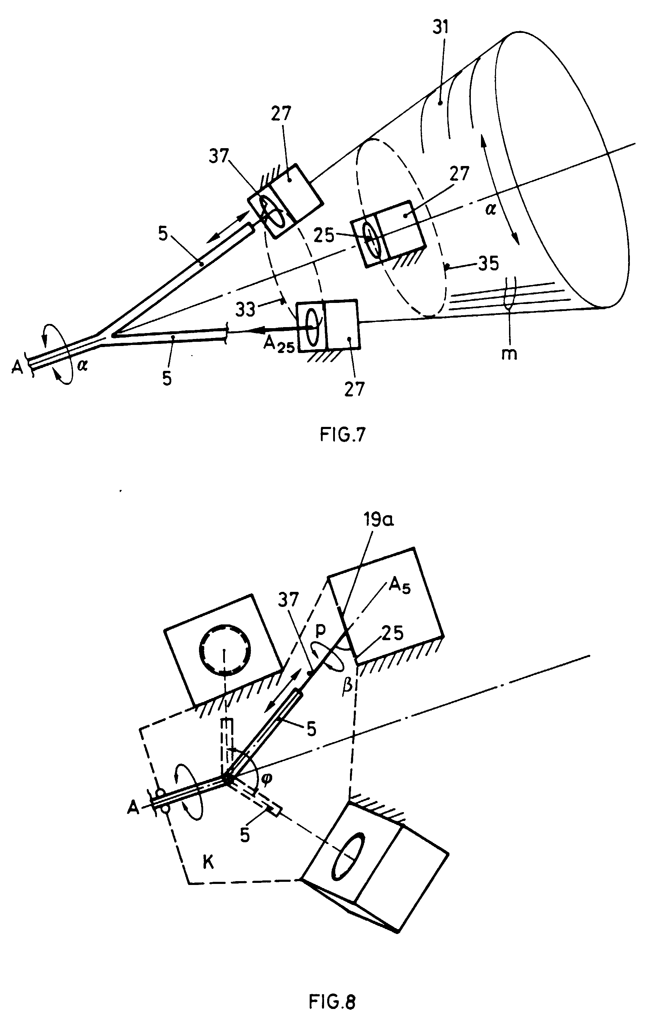

In Fig. 7 ist nun eine weitere Möglichkeit dargestellt, das erfindungsgemässe Vorgehen weiterzubilden. Hier liegen auf dem dargestellten, von den Armen 5 überstrichenen Kegel 31 Stationen auf dem einen Grosskreis 33 und weitere Stationen, wovon nur eine eingetragen ist, auf dem weiteren Grosskreis 35. Die Oeffnungsflächennormalen A₂₅ weisen wiederum in Richtung der Kegelmantellinien m. Um die Oeffnungen 25 von Stationen 27, welche auf unterschiedlichen Grosskreisen 33, 35 liegen, zu bedienen, sind die Arme 5, wie bei 37 schematisch dargestellt, getrieben verlängerbar bzw. verkürzbar, wie über einen pneumatischen Teleskop-Antrieb, z.B. abgedeckt mit hier nicht dargestelltem Balg, analog zum Balg 23 von Fig. 2. Damit wird es möglich, Stationen nicht nur auf einem Grosskreis wie bei der Anlage gemäss den Fig. 2 bis 4 anzuordnen, sondern azimutal, α, versetzt, auf mehreren Kegelgrosskreisen.

Bei einer Weiterbildung des erfindungsgemässen Vorgehens nach Fig. 8 sind die Arme 5, wie wiederum bei 37 dargestellt, auch ausfahrbar bzw. rückholbar und tragen eine Transportplatte 19a. Zusätzlich ist der Kegelwinkel ϕ z.B. getrieben einstellbar, so dass Kegel mit unterschiedlichen Oeffnungswinkeln ϕ überstrichen werden können. Mithin können in weiten Grenzen beliebig angeordnete Stationen bedient werden. Es ist zudem die Trägerplatte 19a gewinkelt in einem Winkel β ≤ 90° am jeweiligen Arm 5 gelagert und, wie bei p dargestellt, um die Armachse A₅ drehbar. Sowohl die Kegelwinkeleinstellung ϕ wie auch das Einfahren und Ausfahren des Armes wie auch die Drehung bei p wird gesteuert getrieben vorgenommen, womit es mit einer solchen Anordnung möglich ist, räumlich praktisch beliebig angeordnete Stationen mit deren Oeffnungen 25 zu bedienen. Gestrichelt ist wiederum die vorzugsweise vorgesehene dichte Transporteinrichtungskammer K dargestellt.

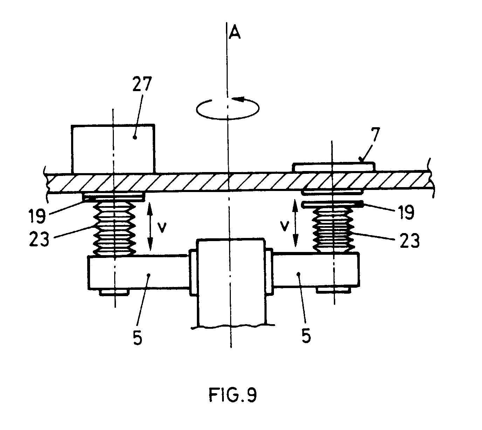

Gemäss Fig. 9 liegt die Drehachse A vertikal. Die Arme 5 sind so L-förmig ausgebildet und montiert, dass die Transportteller horizontal liegen. Dies hat den wesentlichen Vorteil, dass mithin Werkstücke auf den Tellern 19 nicht gehaltert zu werden brauchen. Die armintegrierten Antriebe für die Bewegung v der Teller 19 liegen innerhalb der Bälge 23. Die Transporteinrichtung überstreicht hier eine Zylinderfläche.

Mit dem erfindungsgemässen Konzept bzw. einer entsprechenden Vakuumkammer wird es möglich, ausserordentlich kompakte Anlagen mit mehreren Einzelstationen auszulegen, wobei, wie sich rückblickend auf Fig. 2 ohne weiteres ergibt, falls erwünscht, optimal kurze Transportwege erreichbar sind bzw. die zu konditionierenden Volumina minimalisiert werden können.

## Patentansprüche

1. In sich geschlossene Transportkammer für eine Vakuumbehandlungsanlage mit mindestens zwei Zuführ- und/oder Entnahmeöffnungen für ein Werkstück und einer Werkstück-Transporteinrichtung (3, 5), wobei die Transporteinrichtung (3, 5) in der Kammer (K) mittels eines Drehantriebes um eine Drehachse (A) drehbeweglich gelagert ist und mindestens eine Halterung (19) für ein Werkstück trägt, mit einer Vorschubeinrichtung (5) sowie einem Hub- und Rückholantrieb, wobei die Halterung (19) durch Drehen der Transporteinrichtung (3, 5) selektiv gegenüber einer der Oeffnungen (21, 25) positionierbar und aus dieser Position ein Werkstück durch die Vorschubeinrichtung (5) und den Hub- und Rückholantrieb zur Oeffnung hin bzw. von ihr weg verschiebbar ist, dadurch gekennzeichnet, dass die Halterung (19), die als Transportarm (5) mit integriertem Hub- und Rückholantrieb ausgebildete Vorschubeinrichtung sowie die Transporteinrichtung (3, 5) in der Kammer (K) zu einer Einheit verbunden sind.

2. In sich geschlossene Transportkammer für eine Vakuumbehandlungsanlage mit mindestens zwei Zufuhr- und/oder Entnahmeöffnungen für ein Werkstück und einer Werkstücktransporteinrichtung, wobei die Transporteinrichtung (3, 5) in der Kammer (K) mittels eines Drehantriebes um eine Achse (A) drehbeweglich gelagert ist und mindestens zwei Halterungen (19) je für ein Werkstück trägt, weiter mit mindestens zwei bezüglich der Drehachse (A) mit einer radial gerichteten Bewegungskomponente auf die Werkstücke wirkenden Vorschubeinrichtung (5) sowie einem Hub- und Rückholantrieb hierfür, derart, dass jeweils eine Halterung (19) durch Drehen der Transporteinrichtung (3, 5) selektiv gegenüber einer der Oeffnungen (21, 25) positionierbar und aus dieser Position ein Werkstück durch eine der Vorschubeinrichtungen und den Hub- und Rückholantrieb zur Oeffnung hin bzw. von ihr weg verschiebbar ist, dadurch gekennzeichnet, dass die Vorschubeinrichtungen als Transportarme (5) je mit eigenem, integriertem Hub- und Rückholantrieb ausgebildet sind.

3. Kammer nach einem der Ansprüche 1 oder 2, dadurch gekennzeichnet, dass der Hub- und Rückholantrieb als linearer Antrieb ausgebildet ist.

4. Transportkammer nach einem der Ansprüche 1 bis 3, dadurch gekennzeichnet, dass der Hub- und Rückholantrieb mittels Faltenbalg gekapselt ist.

5. Kammer nach einem der Ansprüche 1 bis 4, dadurch gekennzeichnet, dass die Flächennormalen (A₁₃, A₂₅) der Oeffnungen (13, 25) parallel, radial oder schiefwinklig zur Drehachse (A) der Transporteinrichtung (3, 5) stehen.

6. Kammer nach einem der Ansprüche 1 bis 4, dadurch gekennzeichnet, dass der Hub- und Rückholantrieb parallel, radial oder schiefwinklig zur Drehachse (A) der Transporteinrichtung (3, 5) wirkt.

7. Kammer nach einem der Ansprüche 1, 3 bis 6, dadurch gekennzeichnet, dass mindestens zwei Halterungen mit zugeordneten Transportarmen (5) und je integriertem Hub- und Rückholantrieb vorgesehen sind.

8. Kammer nach einem der Ansprüche 1 bis 7, dadurch gekennzeichnet, dass die Transporteinrichtung (3, 5) bei ihrer Drehbewegung eine Kegelfläche (31) gegebenen Oeffnungswinkels (ϕ) überstreicht oder eine Ebene.

9. Kammer nach einem der Ansprüche 1 bis 8, dadurch gekennzeichnet, dass die Transporteinrichtung (3, 5) bei ihrer Drehbewegung eine Zylinderfläche überstreicht.

10. Kammer nach einem der Ansprüche 1 bis 9, dadurch gekennzeichnet, dass eine Gaszuführ- und/oder Absaugeinrichtung an der Kammer (K) vorgesehen ist.

11. Kammer nach einem der Ansprüche 1 bis 10, dadurch gekennzeichnet, dass die Halterung (19) eine vorzugsweise in jeweiliger Oeffnungsflächennormalen-Richtung bezüglich mindestens einer der Oeffnungen verschiebliche Dichtung umfasst, mit welcher mindestens eine der Oeffnungen (7, 27) abgedichtet wird.

12. Kammer nach Anspruch 11, dadurch gekennzeichnet, dass die Dichtung an einem Teller für die Aufnahme eines Werkstückes vorgesehen ist.

13. Kammer nach Anspruch 12, dadurch gekennzeichnet, dass
- am Teller (19) ein aufragender Zapfen (22) mit über dessen Fläche vorstehenden, gefederten und ausgewölbten Partien (26) vorgesehen ist,
- die Partien, in Zapfen-Achsrichtung betrachtet, so über der Plattenoberfläche gelegen sind, dass nur sie, vorzugsweise nahe ihres Kulminationspunktes (P), mit dem Gegenstand (21) in Kontakt treten.

14. Vakuumbehandlungsanlage mit mindestens einer Kammer nach einem der Ansprüche 1 bis 13, dadurch gekennzeichnet, dass an mindestens einer der Oeffnungen der Kammer eine Schleusenstation oder eine Bearbeitungsstation angeordnet ist.

15. Anwendung der Kammer nach einem der Ansprüche 1 bis 14 in einer Anlage für die Behandlung von scheibenförmigen Werkstükken.

16. Anwendung nach Anspruch 15 für die Behandlung von CD- oder magneto-optischen Speicherplattenscheiben.

17. Transportverfahren für Werkstücke in einer evakuierbaren Kammer nach einem der Ansprüche 2 bis 13, bei der mindestens zwei Werkstücke um eine Drehachse in einer Drehebene gedreht werden und mindestens mit einer bezüglich der Drehachse radialen Bewegungskomponente verschoben werden, dadurch gekennzeichnet, dass die Werkstücke durch je zugeordnete Antriebe schiefwinklig zur Drehachse verschoben werden.

18. Transportverfahren nach Anspruch 17, dadurch gekennzeichnet, dass die Werkstücke mittels einer um die Drehachse gedrehten Anordnung gedreht und auch verschoben werden.

## Claims

1. Closed transport chamber for a vacuum processing device with at least two supply and/or discharge openings for a workpiece and a workpiece transport device (3, 5) where the transport device (3, 5) is mounted to rotate about a rotational axis (A) by means of a rotational drive in chamber (K) and carries at least one holder (19) for a workpiece, with a feed device (5) and a lift and return drive, where the holder (19) can be positioned selectively by rotating the transport device (3, 5) in relation to one of the openings (21, 25) and from this position a workpiece can be moved by the feed device (5) and the lift and return drive towards or away from the opening, characterised in that the holder (19), the feed device constructed as a transport arm (5) with integral lift and return drive and the transport device (3, 5) are connected in the chamber (K) to form one unit.

2. Closed transport chamber for a vacuum processing device with at least two supply and/or discharge openings for a workpiece and a workpiece transport device, where the transport device (3, 5) is mounted to rotate about an axis (A) by means of a rotational drive in a chamber (K) and carries at least two holders (19) each for one workpiece, also with at least two feed devices (5) acting on the workpieces with a radially oriented movement component in relation to the rotational axis (A) and a lift and return drive for this, such that in each case a holder (19) can be positioned selectively in relation to one of the openings (21, 25) by rotating the transport device (3, 5) and from this position a workpiece can be moved by one of the feed devices and the lift and return device towards or away from the opening, characterised in that the feed devices are formed as transport arms (5) each with its own integral lift and return drive.

3. Chamber according to any of claims 1 or 2, characterised in that the lift and return drive is formed as a linear drive.

4. Transport chamber according to any of claims 1 to 3, characterised in that the lift and return drive is encapsulated by bellows.

5. Chamber according to any of claims 1 to 4, characterised in that the surface normals (A₁₃, A₂₅) of the openings (13, 25) lie parallel, radial or at an oblique angle to the rotational axis (A) of the transport device (3, 5).

6. Chamber according to any of claims 1 to 4, characterised in that the lift and return drive acts parallel, radial or at an oblique angle to the rotational axis (A) of the transport device (3, 5).

7. Chamber according to any of claims 1, 3 to 6, characterised in that at least two holders are provided with allocated transport arms (5) and each with an integral lift and return drive.

8. Chamber according to any of claims 1 to 7, characterised in that the transport device (3, 5) in its rotational movement passes over a conical surface (31) of the given opening angle (ϕ) or a plane.

9. Chamber according to any of claims 1 to 8, characterised in that the transport device (3, 5) in its rotational movement passes over a cylindrical surface.

10. Chamber according to any of claims 1 to 9, characterised in that a gas supply and/or extraction device is provided on the chamber (K).

11. Chamber according to any of claims 1 to 10, characterised in that the holder (19) comprises a seal preferably displaceable in the direction of the opening surface normal concerned in relation to at least one of the openings, with which at least one of the openings (7, 27) is sealed.

12. Chamber according to claim 11, characterised in that the seal is provided on a plate for holding a workpiece.

13. Chamber according to claim 12, characterised in that:
- on the plate (19) is provided a raised pin (22) with sprung convex parts (26) projecting over the plate surface,
- the parts, viewed in the axial direction of the pin, lie above the plate surface so that only they come into contact with the object (21), preferably close to their culmination point (P).

14. Vacuum processing device with at least one chamber according to any of claims 1 to 13, characterised in that a lock station or processing station is arranged at least at one of the chamber openings.

15. Use of the chamber according to any of claims 1 to 14 in a system for processing disc-shaped work pieces.

16. Use according to claim 15 for processing CD or magnetooptic memory discs.

17. Transport process for workpieces in an evacuable chamber according to any of claims 2 to 13, in which at least two workpieces are rotated about a rotational axis in a rotational plane and are displaced at least with one radial movement component in relation to the rotational axis, characterised in that the workpieces are displaced by allocated drives at oblique angles to the rotational axis.

18. Transport process according to claim 17, characterised in that the workpieces are rotated and also displaced by means of an arrangement rotated about the rotational axis.

## Revendications

1. Chambre de transport fermée pour une installation de traitement sous vide, comportant au moins deux ouvertures d'amenée et/ou de sortie pour une pièce ; un dispositif de transport de pièces (3, 5), étant précisé que le dispositif de transport (3, 5) est monté mobile en rotation autour d'un axe de rotation (A) dans la chambre (K) grâce à un mécanisme de rotation, et porte au moins un support (19) pour une pièce ; un dispositif d'avance (5) ; et un mécanisme de soulèvement et de rappel, étant précisé que le support (19) est apte à être positionné sélectivement en face de l'une des ouvertures (21, 25) grâce à la rotation du dispositif de transport (3, 5) et qu'à partir de cette position, une pièce est apte à être rapprochée et éloignée de l'ouverture par le dispositif d'avance (5) et le mécanisme de soulèvement et de rappel,
caractérisée en ce que le support (19), le dispositif d'avance conçu comme un bras de transport (5) à mécanisme de soulèvement et de rappel intégré, et le dispositif de transport (3, 5) sont reliés en une unité dans la chambre (K).

2. Chambre de transport fermée pour une installation de traitement sous vide, comportant au moins deux ouvertures d'amenée et/ou de sortie pour une pièce ; un dispositif de transport de pièces, étant précisé que le dispositif de transport (3, 5) est monté mobile en rotation autour d'un axe (A) dans la chambre (K) grâce à un mécanisme de rotation, et porte au moins deux supports (19) pour une pièce chacun ; au moins deux dispositifs d'avance (5) qui agissent sur les pièces avec une composante de mouvement dirigée radialement, par rapport à l'axe de rotation (A) ; et un mécanisme de soulèvement et de rappel pour ces dispositifs d'avance (5), de telle sorte qu'à chaque fois, un support (19) est apte à être positionné sélectivement en face de l'une des ouvertures (21, 25) grâce à la rotation du dispositif de transport (3, 5) et qu'à partir de cette position, une pièce est apte à être rapprochée et éloignée de l'ouverture par l'un des dispositifs d'avance et le mécanisme de soulèvement et de rappel,
caractérisée en ce que les dispositifs d'avance sont conçus comme des bras de transport (5) ayant chacun leur propre mécanisme de soulèvement et de rappel intégré.

3. Chambre selon la revendication 1 ou 2, caractérisée en ce que le mécanisme de soulèvement et de rappel est conçu comme un mécanisme linéaire.

4. Chambre de transport selon l'une des revendications 1 à 3, caractérisée en ce que le mécanisme de soulèvement et de rappel est étanche grâce à un soufflet.

5. Chambre selon l'une des revendications 1 à 4, caractérisée en ce que les normales de surface (A₁₃, A₂₅) des ouvertures (13, 25) sont parallèles, radiales ou obliques par rapport à l'axe de rotation (A) du dispositif de transport (3, 5).

6. Chambre selon l'une des revendications 1 à 4, caractérisée en ce que le mécanisme de soulèvement et de rappel agit parallèlement, radialement ou obliquement par rapport à l'axe de rotation (A) du dispositif de transport (3, 5).

7. Chambre selon l'une des revendications 1, 3 à 6, caractérisée en ce qu'il est prévu au moins deux supports pourvus de bras de transport associés (5) et pourvus chacun d'un mécanisme de soulèvement et de rappel intégré.

8. Chambre selon l'une des revendications 1 à 7, caractérisée en ce que lors de sa rotation, le dispositif de transport (3, 5) balaie une surface conique (31) d'un angle d'ouverture donné (ϕ), ou un plan.

9. Chambre selon l'une des revendications 1 à 8, caractérisée en ce que lors de sa rotation, le dispositif de transport (3, 5) balaie une surface cylindrique.

10. Chambre selon l'une des revendications 1 à 9, caractérisée en ce qu'il est prévu sur la chambre (K) un dispositif d'amenée de gaz et/ou d'aspiration.

11. Chambre selon l'une des revendications 1 à 10, caractérisée en ce que le support (19) comprend un joint d'étanchéité qui est de préférence mobile par rapport à l'une au moins des ouvertures dans le sens de la normale de surface d'ouverture, et grâce auquel l'une au moins des ouvertures (7, 27) est étanche.

12. Chambre selon la revendication 11, caractérisée en ce que le joint d'étanchéité est prévu sur un plateau destiné à recevoir une pièce.

13. Chambre selon la revendication 12, caractérisée
- en ce qu'il est prévu sur le plateau (19) une tige dressée (22) qui présente des parties (26) saillant sur sa surface, élastiques et bombées,
- en ce que ces parties, considérées dans le sens axial de la tige, sont placées sur la surface de la plaque de manière à être les seules à venir en contact avec l'objet (21), de préférence près de leur point culminant (P).

14. Installation de traitement sous vide comprenant au moins une chambre selon l'une des revendications 1 à 13, caractérisée en ce qu'un poste sas ou un poste de traitement est disposé au niveau de l'une au moins des ouvertures de la chambre.

15. Utilisation de la chambre selon l'une des revendications 1 à 14 dans une installation pour le traitement de pièces en forme de disques.

16. Utilisation selon la revendication 15 pour le traitement de CD ou de disques de mémoires magnéto-optiques.

17. Procédé de transport pour des pièces dans une chambre apte à être mise sous vide selon l'une des revendications 2 à 13, selon lequel au moins deux pièces sont mises en rotation dans un plan de rotation autour d'un axe de rotation et sont déplacées au moins avec une composante de mouvement radiale par rapport à l'axe de rotation,
caractérisé en ce que les pièces sont déplacées obliquement par rapport à l'axe de rotation par des mécanismes associés.

18. Procédé de transport selon la revendication 17, caractérisé en ce que les pièces sont déplacées en rotation à l'aide d'un dispositif qui tourne autour de l'axe de rotation, et aussi en translation.
